# EUROPEAN PATENT APPLICATION

(11) **EP 4 745 111 A1**
(43) Date of publication of application: **20.05.2026**
(21) Application number: 25214014.0
(22) Date of filing: 06.11.2025
(51) Int. Cl.: C04B 35/185, C04B 35/195, C04B 35/56, C04B 35/563, C04B 35/565, C04B 35/653, C04B 35/80, C04B 35/628

(54) **MULTI-PHASE CERAMIC MATRIX COMPOSITE**

(30) Priority: 12.11.2024 US 202418944815
(71) Applicant: RTX Corporation, Farmington, CT 06032 (US)
(72) Inventor: JACKSON III, Richard Wesley, Mystic, 06355 (US); BEALS, James T., West Hartford, 06107 (US); KENNEDY, Zachary, Hamden, 16514 (US); SPAETH, Andrew Douglas, Holden, 01520 (US)
(74) Representative: Dehns

(57) **Abstract**

A method is provided for preparing a ceramic matrix composite (CMC) having a matrix with a SiC matrix phase and an oxide matrix phase. In one process embodiment, a CMC preform containing fiber tows to chemical vapor infiltration of SiC to form a SiC matrix phase. A metal oxide layer is then deposited on surfaces of the SiC matrix phase by atomic layer deposition. The resultant preform is then subjected to slurry infiltration to introduce ceramic particles, e.g., an alumina powder, to fill void spaces in the preform. The CMC preform is then subjected to melt infiltration by a molten metal oxide. The melt infiltrated CMC preform is subjected to one or more heat treatments to react the molten oxide and powder(s) and form a crystalline oxide matrix phase.

## Description

### FIELD OF THE INVENTION

The present disclosure relates generally to methods for manufacturing ceramic matrix composites (CMCs). In particular, the present disclosure concerns manufacturing CMC components with multiple phases.

### BACKGROUND OF THE INVENTION

Gas turbine engines, in general, include a fan section, a compressor section, a combustion chamber, and a turbine section. Air enters through the fan section and is compressed in the compressor section before being introduced into the combustion section. In the combustion section, the air is mixed with fuel and ignited to generate a high-energy, high temperature gas flow. The high-energy, high temperature gas flow is expanded in the turbine section which is used to create thrust and drive the compressor and fan sections.

Certain components of gas turbine engines are thus exposed to the high-energy, high temperature gas flow (flow path components). Therefore, it desirable that such components be made of materials with high heat resistance such as ceramic matrix composites (CMCs). CMC components can withstand much higher operating temperatures (e.g., greater than 1400°C) than components composed of superalloys.

To produce CMCs, a preform, made from woven fiber tows (e.g., made from SiC or C fibers) held together by a binder can be initially prepared. The preform can then be infiltrated with a particulate ceramic matrix precursor material followed by melt infiltration of a reactant to react with the precursor material to form the matrix material that surrounds the fiber tows.

To modify the properties of a matrix material, attempts have been made to combine the carbide matrix phase with an oxide phase by hybrid processing techniques involving the use of different precursors and melt reactants. Such hybrid processing to produce a matrix containing both a carbide phase and an oxide phase can yield CMC materials with lower porosity and enhance overall thermal, chemical and environmental of the CMC material. However, the processing conditions employed in such hybrid processing techniques can be limited due to the need to avoid atmospheres with high oxygen content. The presence of oxygen during such processing can lead to oxidation of the carbide material (e.g. SiC) resulting in formation of CO gas. The formation and release of CO, in turn, leads to degradation of the CMC material.

For example, the reaction of SiC with oxygen releases CO and forms a SiO₂ layer and/or gaseous SiO. The amounts of SiO₂ and SiO formed is dependent on the amount oxygen in the atmosphere. Thus, if the processing atmosphere has a high oxygen partial pressure (e.g., an atmosphere), an SiO₂ layer may form. Conversely, when processing in an inert atmosphere (that still contains at least some oxygen), formation of SiO₂ may be suppressed leading to a greater tendency for gaseous SiO formation. In either case, the reaction results in loss of the carbide material and the pressure of the released CO gas can be high enough to create CO bubbles with the matrix material which can result in pore formation and can inhibit glass flow.

There is thus a continuing need for alternative and/or improved manufacturing methods for producing CMC materials, particularly for producing CMC materials used in components that will be exposed to high temperature gas flow.

### SUMMARY OF THE INVENTION

In general, the present disclosure relates to methods for preparing CMC materials with multiphase matrices, as well as intermediates and final products produced during such methods. In particular, the present disclosure relates to methods for preparing CMC materials, and products produced thereby, having a carbide matrix phase and an oxide matrix phase.

The present disclosure is directed, in a first aspect, to a method for preparing a ceramic matrix composite (CMC) having a matrix with a carbide (e.g., SiC) matrix phase and an oxide matrix phase, comprising:
(a) preparing a CMC preform containing fiber tows (e.g., SiC fiber tows);
(b) infiltrating the CMC preform with a carbide matrix phase by chemical vapor infiltration (CVI);
(c) depositing one or more metal oxide layer(s) on surfaces of the CMC preform with carbide matrix phase by atomic layer deposition (ALD);
(d) subjecting the CMC preform with carbide matrix and metal oxide layer(s) to slurry infiltration using a slurry containing alumina powder, mullite powder, alkaline alumina silicate powder, and/or rare earth silicate powder, and optionally SiC powder as a filler, wherein the powders fill void spaces within the infiltrated preform;
(e) introducing molten oxide into the slurry infiltrated CMC preform by melt infiltration; and
(f) subjecting the melt infiltrated CMC preform to one or more heat treatments to react the molten oxide and powder(s) to form a crystalline oxide matrix phase and obtain a ceramic matrix composite having matrix that has a carbide matrix phase and an oxide matrix phase.

In yet another aspect, the present disclosure is directed to a CMC preform intermediate that comprises fiber tows within a carbide matrix and one or more metal oxide layer(s) deposited by ALD on surfaces of the carbide matrix, for example, the preform intermediate contains 30 - 50 vol.% fiber tows and 10 - 30 vol.% of carbide matrix.

In yet a further aspect, the present disclosure is directed to CMC jet engine component(s) having a matrix with a carbide matrix phase and an oxide matrix phase, in which the component(s) is prepared by a process comprising:
(a) preparing a CMC preform containing fiber tows;
(b) infiltrating the CMC preform with a carbide matrix phase by chemical vapor infiltration (CVI);
(c) depositing one or more metal oxide layer(s) on surfaces of the CMC preform with carbide matrix phase by atomic layer deposition (ALD);
(d) subjecting the CMC preform with carbide matrix and metal oxide layer(s) to slurry infiltration using a slurry containing alumina powder, mullite powder, alkaline alumina silicate powder, and/or rare earth silicate powder, and optionally SiC powder as a filler, wherein the powders fill void spaces within the infiltrated preform, and heating the slurry infiltrated CMC preform to melt the powders and obtain a ceramic matrix composite having matrix that has an carbide matrix phase and an oxide matrix phase;
(e) introducing molten oxide into the slurry infiltrated CMC preform by melt infiltration; and
(f) subjecting the melt infiltrated CMC preform to one or more heat treatments to react the molten oxide and powder(s) to form a crystalline oxide matrix phase and obtain a ceramic matrix composite having matrix that has a carbide matrix phase and an oxide matrix phase.

In yet a further aspect, which the Applicant expressly reserves the right to claim independently, the present disclosure is directed to a CMC preform intermediate which contains fiber tows (e.g., SiC fiber tows) within a carbide matrix (e.g., SiC carbide matrix) along with infiltrated particles (e.g., alumina and SiC particles) and one or more metal oxide layer(s) deposited by ALD on surfaces of the carbide matrix and infiltrated particles.

In yet a further aspect, which the Applicant expressly reserves the right to claim independently, the present disclosure is directed to a CMC material having a carbide matrix phase and an oxide matrix phase comprising: 30 - 50 vol.% of fiber tows and 50 - 70 vol.% matrix, wherein the carbide matrix phase is 10 - 30 vol.%, relative to the total volume of the composite, and the oxide matrix phase is 20 - 60 vol.%, relative to the total volume of the composite, and wherein the porosity of the material is less than 5 vol.%.

In further examples of the present disclosure, including further examples of the above, the CMC preform is prepared by stacking two-dimensional woven ceramic fiber plies containing ceramic fiber tows and a binder.

In further examples of the present disclosure, including further examples of the above, the CMC preform is a three-dimensional weave of ceramic fiber tows wherein the fiber tows are optionally embedded within a binder.

In further examples of the present disclosure, including further examples of the above, prior to infiltration of the CMC preform with a SiC matrix phase, the fiber tows are coated with an interphase, the interphase being selected from boron nitride, silicon-doped boron nitride, or boron-doped carbon.

In further examples of the present disclosure, including further examples of the above, the carbide matrix is a silicon carbide, boron carbide, hafnium carbide, or zirconium carbide matrix, and the one or more metal oxide layer(s) are selected from alumina, silicon dioxide, hafnium oxide, ytterbium oxide, and yttrium oxide.

In further examples of the present disclosure, including further examples of the above, the fiber tows are SiC fiber tows and the carbide matrix is SiC.

In further examples of the present disclosure, including further examples of the above, a plurality of metal oxide layers are deposited by ALD, wherein the metal oxide layers deposited by ALD are the same or different.

In further examples of the present disclosure, including further examples of the above, one of more silicon dioxide layers are deposited by ALD and then one or more alumina layers are deposited by ALD.

In further examples of the present disclosure, including further examples of the above, the total thickness of the one or more metal oxide layers deposited by ALD is 10 to 200 nm (such as 50 - 200 nm or 50 to 100 nm).

In further examples of the present disclosure, including further examples of the above, the resultant ceramic matrix composite contains 30 - 50 vol.% fiber tows and 50 - 70 vol.% matrix, wherein the carbide matrix phase is 10 - 30 vol.%, relative to the total volume of the composite, and the oxide matrix phase is 20 - 60 vol.%, relative to the total volume of the composite.

In further examples of the present disclosure, including further examples of the above, cordierite (Mg₂Al₄Si₅O₁₈), mullite (Al₆Si₂O₁₃), and/or sapphirine (Mg₄Al₁₀Si₂O₂₃) make up greater than 75 vol.% of the of the oxide matrix phase.

In further examples of the present disclosure, including further examples of the above, in the resultant ceramic matrix composite the volume fraction of the pores that are filled with alumina is 25 vol.% to 75 vol.% relative to the total pore volume.

In further examples of the present disclosure, including further examples of the above, in the resultant ceramic matrix composite the volume of the pores that are filled with mullite is 35 vol.% to 85 vol.% relative to the total pore volume.

In further examples of the present disclosure, including further examples of the above, in the resultant ceramic matrix composite the volume of the pores that are filled with carbide (e.g., SiC) is 1 vol.% to 50 vol.% relative to the total pore volume.

In further examples of the present disclosure, including further examples of the above, molten oxide infiltration is performed at 1350°C to 1500°C (e.g., 1370°C -1420°C).

In further examples of the present disclosure, including further examples of the above, in (e) the heat treatment(s) are performed at a temperature of 1100°C to 1500°C.

In further examples of the present disclosure, including further examples of the above, in the CMC preform intermediate the fiber tows are coated with an interphase, the interphase being selected from boron nitride, silicon-doped boron nitride, or boron-doped carbon.

In further examples of the present disclosure, including further examples of the above, in the CMC preform intermediate the carbide matrix is a silicon carbide, boron carbide, hafnium carbide, or zirconium carbide matrix, and the one or more metal oxide layer(s) are selected from alumina, silicon dioxide, hafnium oxide, ytterbium oxide, and yttrium oxide.

In further examples of the present disclosure, including further examples of the above, in the CMC preform intermediate the total thickness of the one or more metal oxide layers deposited by ALD is 10 to 200 nm (such as 50 - 200 nm or 50 to 100 nm).

### BRIEF DESCRIPTION OF FIGURES

The features of the disclosure believed to be novel and the elements characteristic of the invention are set forth with particularity in the appended claims. The figures are for illustration purposes only and are not drawn to scale. The disclosure itself, however, both as to organization and method of operation, can best be understood by reference to the description of the preferred embodiment(s) which follows, taken in conjunction with the accompanying drawings in which:
Fig. 1 is a flow chart showing steps of a first process embodiment for preparation of a CMC material having a carbide matrix phase and an oxide matrix phase.
Fig. 2 is a flow chart showing steps of an alternative process embodiment for preparation of a CMC material having a carbide matrix phase and an oxide matrix phase.
Fig. 3 is a cross section of 2 plies of a preform prior to deposition of ALD metal oxide layer.
Fig. 4 is a cross section of 2 plies of a preform after deposition of ALD metal oxide layer.
Fig. 5 is a cross section of 2 plies of a preform after deposition of ALD metal oxide layer and after slurry infiltration.
Fig. 6 is a cross section of 2 plies of a preform after deposition of ALD metal oxide layer in which slurry infiltration preceded ALD deposition.

### DETAILED DESCRIPTION OF THE INVENTION

The embodiments of the present disclosure can comprise, consist of, and consist essentially of the features and/or steps described herein, as well as any of the additional or optional ingredients, components, steps, or limitations described herein or would otherwise be appreciated by one of skill in the art. It is to be understood that all concentrations disclosed herein are by weight percent (wt. %.) based on a total weight of the composition unless otherwise indicated.

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of the embodiments of the inventive concepts, numerous specific details are set forth in order to provide a more thorough understanding of the inventive concepts. It will be apparent to one skilled in the art, however, having the benefit of the instant disclosure that the inventive concepts disclosed herein may be practiced without these specific details.

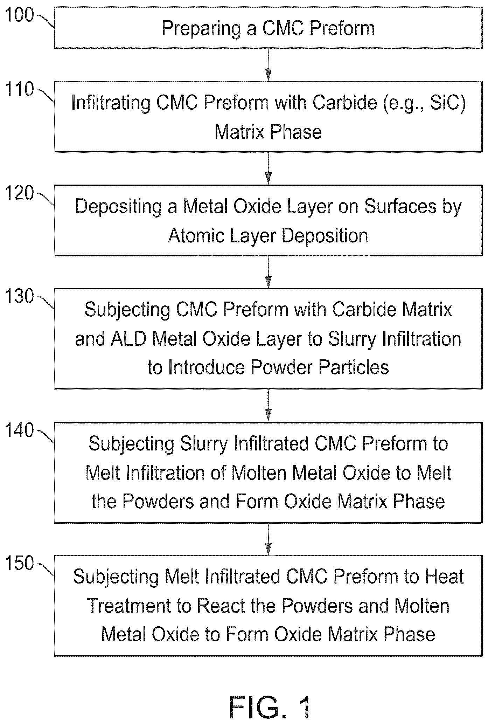

Fig. 1 is a process flow chart for preparing a CMC material having both a carbide (e.g., SiC) matrix phase and an oxide matrix phase. In the first step 100, a CMC preform is prepared. The preform serves as the initial framework for creating the CMC component. The preform contains ceramic fibers, or bundles of ceramic fibers called tows, held together with a binder. The fibers can take the form of layers of unidirectional fibers or can be in the form of woven fibers. For example, that fibers can be woven into a two-dimensional fabric sheets or plies and then stacked into to form the preform. This is sometimes referred to as a laying up process. Alternatively, the preform can be in the form of a three-dimensional weave wherein, for example, a plurality of waft fibers are interwoven through a plurality of weft fiber layers.

Polymeric binders such as polyvinyl alcohol (PVA) or polyvinyl butyral (PVB) can be used to help hold the fibers/plies together to provide a certain rigidity to the preform. Following layup, the binder can be removed by heat treatment, during which the binder is burned or vaporized, or can be removed by solvent dissolution and washing.

The fibers/filaments used in the CMC preforms may be, for example, silicon carbide (SiC), carbon, mullite, zirconium carbide (ZrC), hafnium carbide (HfC), silicon nitride, aluminum oxide, or combinations thereof. The ceramic fibers may also be oxycarbide-, oxynitride-, carbonitride-, silicate-, boride-, phosphide-, or oxide-based fibers. In still further examples, the fibers are fully crystalline, partially crystalline, or predominantly amorphous or glassy. In one particular example, the fibers are SiC fibers.

After removal of the binder, the fibers of the preform can, optionally, be provided with one or several interphases deposited prior to introduction of matrix material. This interphase coating can be, for example, a coating of boron nitride, silicon-doped boron nitride, boron-doped carbon, boron carbide, titanium nitride, or zirconium nitride which is applied by chemical vapor infiltration (CVI). The interphase coating is used to ensure that the composite will fail in a non-brittle manner by preventing crack formation and/or propagation.

The resultant preform exhibits a certain porosity. For example, the preform can be formed with fibers forming 30-50 vol.% of the overall preform volume, for example 35-50 vol.%, 30-45 vol.%, or 35-45 vol.%. The substantial porosity of the preform will be utilized in forming the matrix during further processing.

Step 110 begins the process of forming the matrix of the composite by using CVI to introduce a carbide matrix, for example, a matrix made from silicon carbide, boron carbide, hafnium carbide, or zirconium carbide. In a particular embodiment, the carbide matrix is a SiC matrix. CVI involves introducing gaseous precursors into the porous CMC preform. These precursors react at the surface of the fibers (or the surface of the interphase if present), depositing material and filling the voids. In this embodiment of the inventive process, the introduced carbide material (e.g., SiC) only partially fills the voids/pores of the preform. For example, the carbide matrix can fill 5% to 55 vol.% (such as 10-50 vol.%, 20-40 vol. %, or 25-35 vol. %) of the available porosity. By way of another example, if before introduction of the carbide matrix the preform has a porosity of 50-70 vol.%, following deposition of the carbide matrix, the porosity can be, for example, 30 to 60 vol.% (such as 35-50 vol.%, 40-55 vol. %, or 45-60 vol. %).

As noted above, the carbide matrix (e.g., SiC matrix) is susceptible to oxidation which can lead to undesirable formation of CO gas during further processing such as melt infiltration. This imposes a limitation on the environment used in downstream processing steps to atmospheres with low O₂ partial pressure. To avoid this problem and expand the range of useable processing environments during, for example, melt infiltration, the disclosed process uses a layer of sealing material on the surfaces of the carbide matrix to limit exposure of the carbide to oxygen and thereby reduce or eliminate carbide oxidation.

Therefore, in step 120 of Fig. 1, surfaces of the carbide matrix, e.g., SiC matrix and surfaces of the fiber tows not covered by the SiC matrix, within the preform are covered by one or more thin layers using atomic layer deposition (ALD) to form a CMC preform intermediate. The metal oxide layers applied by ALD can be the same or different. These thin metal oxide layers act as barrier to limit the amount of oxygen reaching the carbide matrix during subsequent formation of the oxide phase. By reducing the amount of oxygen that comes into contact with the carbide phase, oxidation of the carbide phase is reduced or eliminated.

As mentioned above, more than one metal oxide layer can be applied by ALD. For example, one or more SiO₂ layers can be applied by ALD and then one or more Al₂O₃ layers can be applied by ALD. Alternatively, the ALD process can deposit a trilayer coating such as SiO₂/Al₂O₃/MgO or SiO₂/Al₂O₃/ SiO₂.

ALD is a deposition technique that allows the application of ultra-thin, conformal, dense films to surfaces. Generally, advantages of ALD include the ability to provide uniform deposition of layers, the ability to control layer thickness, and the ability to provide for layer deposition on complex three-dimensional surfaces.

In general, in an ALD process, the substrate is paced in a chamber at suitable temperature and reduced pressure, and then precursor materials are sequentially injected into the chamber, with optional purging in between injections. For example, to deposit metal oxide films by an ALD process, two precursors are usually used where one precursor acts as a metal source and the other acts as an oxygen source. The precursors react with the surface to be coated and a thin film is deposited by repeated, cyclic exposure to the two separate precursors.

Suitable metal oxides layers include alumina, silicon dioxide, hafnium oxide, ytterbium oxide, yttrium oxide, and mixtures thereof. Precursors used in ALD for alumina, silicon dioxide, hafnium oxide, ytterbium oxide, yttrium oxide are known within the art. For example, suitable ALD precursors for aluminum oxide layers are trimethylaluminum (TMA) and water, or TMA and ozone. Suitable silicon dioxide precursors include tetraethoxysilane, tris(dimethylamino)-silane, or silicon tetrachloride with water. For hafnium oxide layers, suitable ALD precursors include tetrakis(dimethylamido)hafnium and water. For ytterbium oxide, suitable ALD precursors include tris(cyclopentadienyl)ytterbium and water. For yttrium oxide layers, suitable ALD precursors include tris(ethylcyclopentadienyl)yttrium and water, or tris(methylcyclopentadienyl)yttrium and water.

ALD is generally performed at temperatures lower than those used in chemical vapor deposition (CVD). For example, ALD reactions can be performed at temperatures of generally <400°C, e.g., <350°C, such as 120°C to 300°C.

The thickness of the applied metal oxide layer(s) can vary by varying the number of sequential applications of the precursors to the substrate during the ALD process. For example, the total thickness of the metal oxide layer(s) can be 10 to 200 nm (such as 50 - 200 nm or 50 to 100 nm or 50 to 75 nm).

Application of the ALD layer forms a preform intermediate. This preform intermediate contains fiber tows (e.g., SiC fiber tows) within a carbide matrix (e.g., SiC carbide matrix) and one or more metal oxide layer(s) deposited by ALD on surfaces of the carbide matrix. For example, the preform intermediate can contain, for example, 30 - 50 vol.% (such as 35 - 45 vol% or 30 - 45 vol%) fiber tows and, for example, 10 - 30 vol.% (such as 10 - 25 vol% or 15 - 30 vol%) of carbide matrix.

After the formation of the metal oxide layer(s), additional processing can occur with respect to the matrix formation. Thus, referring again to Fig. 1, in step 130 the CMC preform with carbide matrix and ALD metal oxide layer(s), or CMC preform intermediate, is subjected to slurry infiltration to introduce a powdered ceramic material into the preform. In this embodiment of the inventive process, the powdered ceramic material acts as one of the reactants used to form an oxide matrix in the preform. The powdered ceramic material within the slurry can be alumina powder, mullite powder, alkaline alumina silicate powder, and/or rare earth silicate powder, and optionally can further contain SiC powder as a filler. The addition of SiC particles can increase the thermal conductivity of the overall CMC system. During the slurry infiltration, the powders fill pores or void spaces within the preform.

The particle size of the powders is selected to be of a size that will permit the particles to enter and be retained within the pores of the preform. For example, the particle size of the powders used in the slurry can be 50 nm to 50 µm, for example, 100 nm to 25 µm 500 nm to 40 µm or 1 µm to 25 µm or 10 µm to 35 µm or 25 µm to 50 µm. The particles can also have a multimodal distribution such as a bimodal or trimodal distribution. For example, the particles can include 5 µm to 35 µm particles (e.g., alumina) suspended in a suspension of colloidal particles (e.g., alumina) having a particles size of 50 nm to 100 nm. The carrier fluid for the slurry can be a liquid that is relatively inert with respect to the materials of the preform to be infiltrated and that will facilitate penetration of the slurry into the pore/voids of the preform. Suitable carrier liquids include water or organic liquids such as isopropanol or methanol. The liquid may also contain binders, surfactants, and/or dispersants to aid in forming a suspension of the powder in the slurry. The liquid may also be a colloidal suspension. The slurry infiltration can be carried out at relatively normal temperatures, for example, 15 to 50°C such as 15 to 30°C or 20 to 30°C or room temperature.

Following slurry infiltration, the resultant slurry infiltrated preform is subjected to melt infiltration in step 140. In melt infiltration 140, a molten oxide is introduced into the preform to react with the powder particles deposited by slurry infiltration and thereby initiate formation of the metal oxide matrix. Metal oxides that can be used for melt infiltration include, for example, Al₂O₃, SiO₂, B₂O₃, alkaline earth metal oxides, transition metal oxides, and rare earth metal oxides, used alone or in combination. According to one embodiment, combinations of metal oxides are used wherein the metal oxides are selected from MgO, Al₂O₃, SiO₂, CaO, BaO, SrO, Y₂O₃, Yb₂O₃, Lu₂O₃, and Gd₂O₃. According to another embodiment, the combination of metal oxides involves a primary oxide selected from, for example, MgO, Al₂O₃, and SiO₂, combined with one or more addition metal oxides selected from alkaline earth metal oxides (such as CaO and BaO) rare earth oxides (such as Y₂O₃, Yb₂O₃, Lu₂O₃, and Gd₂O₃), transition metal oxides, and B₂O₃.

Process conditions for melt infiltration include, for example, a temperature within a range of, for example, about 1300°C to 1550°C, such as 1350°C to 1485°C, 1350°C to 1500°C, or 1370°C -1420°C. The pressure can be a positive pressure or the process can be conducted under vacuum. The pressure can be, for example, between 0.001 mbar (0.1 Pa) and 10 bar (1 MPa).

Due to the metal oxide layer deposited by ALD, the susceptibility of the carbide matrix to oxidation is reduced. Thus, it is possible to use atmosphere with higher oxygen content during the melt infiltration in comparison to other melt infiltrations involving a preform with carbide matrix without a resultant appreciable release of CO. Suitable atmospheres for melt infiltration include, for example, mixtures of O₂ and inert gases, such as N₂ or Ar, where the oxygen partial pressure is between is between, for example, 10⁻⁴ and 10⁻¹ atm (10 Pa and 10 kPa), and mixtures of CO and CO₂ where the CO pressure is between 10⁻³ and 10⁻¹ atm (100 Pa and 10 kPa).

After melt infiltration, in step 150 the melt infiltrated CMC preform is subjected to one or more heat treatments to react the molten oxide and powder(s) to form a crystalline oxide matrix phase and obtain a ceramic matrix composite having matrix that has a carbide matrix phase and an oxide matrix phase. The heat treatment(s) are performed at, for example, a temperature of 1100°C to 1500°C such as 1100°C to 1400°C or 1250°C to 1450°C, 1350°C to 1450°C, or 1375°C to 1425°C.

The resultant ceramic matrix composite exhibits both a carbide matrix phase and an oxide matrix phase, i.e. a multiphase matrix. The successive formation of a carbide matrix followed by an oxide matrix yields a layered structure wherein surfaces of the carbide matrix are covered by the oxide matrix.

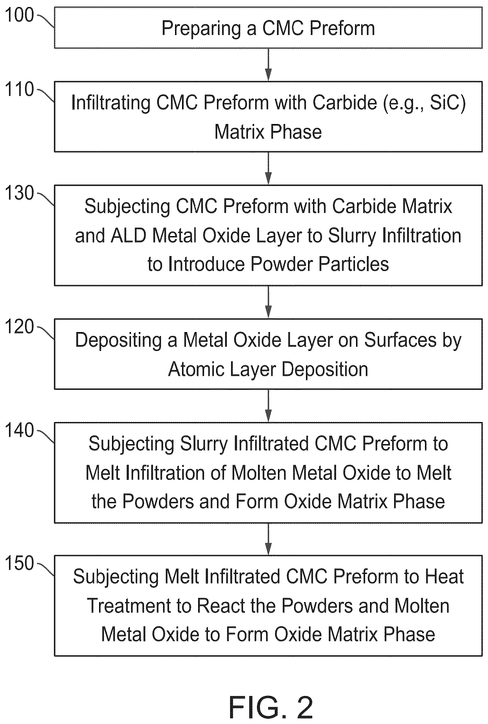

An alternative of the above described procedure involves introducing the one or more ALD metal oxide layers after the slurry infiltration for introduction of powder particles. See Fig. 2. In comparison to the flow chart of Fig. 1, in the flow chart of Fig. 2, step 130 is performed before step 120. In this embodiment, the metal oxide layer(s), applied by ALD, would be applied to not only surfaces of the SiC matrix and surfaces of the fiber tows not covered by the SiC matrix, but would also be applied to surfaces of the particles introduced during the slurry infiltration such as alumina particles and SiC filler particles. In this exemplary embodiment, the SiC filler particles, coated with the ALD metal oxide coating, would be less susceptible to oxidation during the melt infiltration thereby reducing the potential for release of SiC gas.

In addition, the presence of the ALD metal oxide layer on the infiltrated powder particles may facilitate the melt infiltration. For example, an Al₂O₃ ALD coating on SiC filler particles may enhance capillary flow of the molten glass into the CMC since the surface energy of the molten glass/Al₂O₃ interface is lower than the surface energy of the molten glass/SiC particle interface.

In this embodiment, the application of the ALD layer also forms a preform intermediate. In this case, the preform intermediate contains fiber tows (e.g., SiC fiber tows) within a carbide matrix (e.g., SiC carbide matrix) along with infiltrated particles and one or more metal oxide layer(s) deposited by ALD on surfaces of the carbide matrix and infiltrated particles.

In a further modification of the method, prior to slurry infiltration, the particles used in the slurry infiltration (e.g., alumina and SiC powder particles) can be coated with a metal oxide metal layer by ALD. This modification can be used in the method embodiment shown in Fig. 1 or in the alternative embodiment wherein step 130 is performed before step 120.

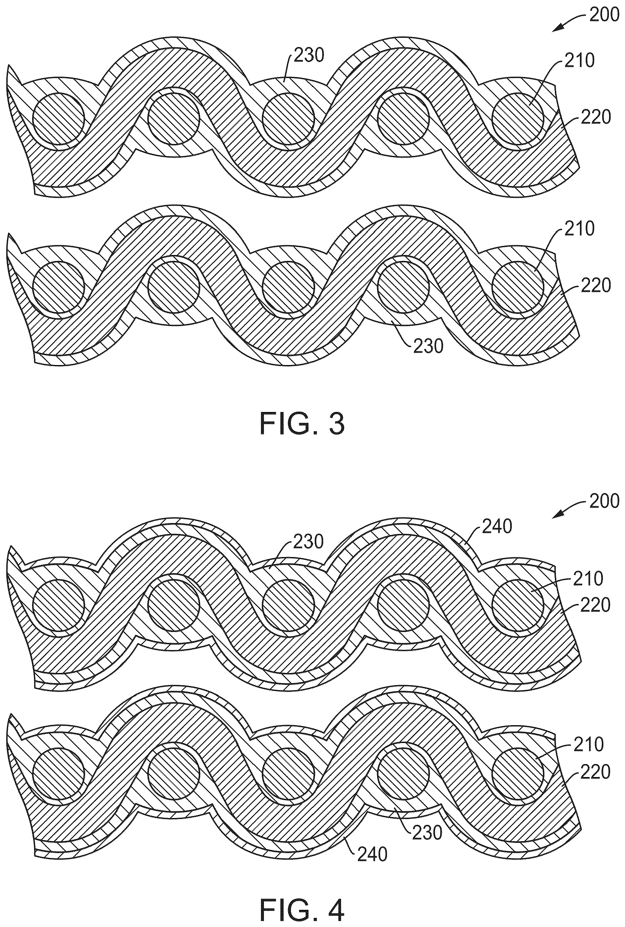

Figs. 3-6 illustrate cross sections of the preform at different points in the process. Fig. 3 shows a cross section of 2 plies of a CMC preform 200 after deposition of the carbide matrix and prior to formation of the ALD metal oxide layer. In this embodiment, the plies are shown as two-dimensional weaves of warp 210 and weft 220 fiber tows. The fibers 210/220 (which optionally have an interface coating) are coated with carbide matrix material 230 (e.g., SiC matrix material). See step 110 of the flowchart of Fig. 1.

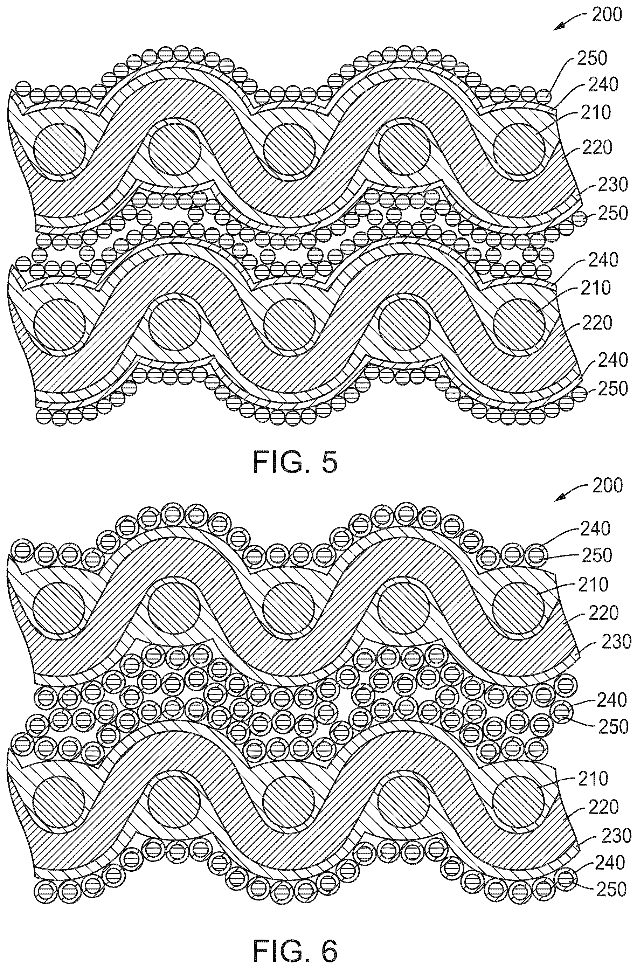

Fig. 4 shows the same cross section of 2 plies after the deposition of a metal oxide layer 240 by ALD and prior to slurry infiltration. See step 120 of the flowchart of Fig. 1. Fig. 5 shows the same cross section of 2 plies after the ALD deposition of a metal oxide layer and after slurry infiltration wherein the powder particles 250 are deposited within voids of the preform 200. See step 130 of the flowchart of Fig. 1.

Fig. 6 shows a cross section of 2 plies of a CMC preform 200 which is treated in accordance with the process of Fig. 2. Thus, in this embodiment, ALD layer is formed after slurry infiltration. As shown in Fig. 6, ALD layer is deposited onto the carbide matrix material 230 and infiltrated powder particles 250.

In terms of vol.%, the resultant ceramic matrix composite can contain, for example, 30 - 50 vol.% fiber tows and 50 - 70 vol.% matrix, wherein the carbide matrix phase is 10 - 30 vol.%, relative to the total volume of the composite, and the oxide matrix phase is 20 - 60 vol.%, relative to the total volume of the composite. The oxide matrix can comprise cordierite (Mg₂Al₄Si₅O₁₈), mullite (Al₆Si₂O₁₃), and/or sapphirine (Mg₄Al₁₀Si₂O₂₃). For example, cordierite, mullite, and/or sapphirine make up at least 75 vol.% of the of the oxide matrix phase, such as 80 vol.%, 85 vol.%, 90 vol.%, or 95 vol.%.

In comparison to the preform before the formation of the multiphase matrix, the volume fraction of the pores that are filled with alumina is, for example, 25 vol.% to 75 vol.% relative to the total pore volume, such as 30 vol.% to 70 vol.%, 40 vol.% to 65 vol.%, or 45 vol.% to 60 vol.%. Similarly, the volume of the pores that are filled with mullite is 35 vol.% to 85 vol.% relative to the total pore volume, such as 40 vol.% to 75 vol.%, 50 vol.% to 65 vol.%, or 50 vol.% to 60 vol.%. Also, the volume of the pores that are filled with SiC is 1 vol.% to 50 vol.% relative to the total pore volume, such as 15 vol.% to 50 vol.%, 20 vol.% to 45 vol.%, or 30 vol.% to 40 vol.%.

The inventive process provides the ability to achieve a high density ceramic matrix composite. The resultant CMC material with carbide matrix phase and oxide matrix phase can contain, for example 30 - 50 vol.% of fiber tows and 50 - 70 vol.% matrix, wherein the carbide matrix phase is 10 - 30 vol.%, relative to the total volume of the composite, and the oxide matrix phase is 20 - 60 vol.%, relative to the total volume of the composite, and wherein the porosity of the material is less than 5 vol.%, such as 4.5 vol.%, 4.0 vol.%, 3.0 vol.%, 2.0 vol.%, or 1 vol.%.

The present disclosure provides an efficient method for forming cooling cavities beneath radial flanges. These cooling cavities provide a means for effectively cooling the interior of CMC components exhibiting flanges and thereby reduce the formation of thermal gradients at regions of high thickness and in turn reduce through-thickness and in-plane thermal stresses.

While the present disclosure has been particularly described, in conjunction with specific preferred embodiments, it is evident that many alternatives, modifications and variations will be apparent to those skilled in the art in light of the foregoing description. It is therefore contemplated that the appended claims will embrace any such alternatives, modifications and variations as falling within the true scope of the present disclosure.

## Claims

1. A method for preparing a ceramic matrix composite (CMC) having a matrix with a carbide matrix phase and an oxide matrix phase, comprising:
(a) preparing a CMC preform (200) containing fiber tows (210, 220);
(b) infiltrating the CMC preform with a carbide matrix phase (230) by chemical vapor infiltration (CVI);
(c) depositing one or more metal oxide layer(s) (240) on surfaces of the CMC preform (210) with carbide matrix phase (230) by atomic layer deposition (ALD);
(d) subjecting the CMC preform (200) with carbide matrix (230) and metal oxide layer(s) (240) to slurry infiltration using a slurry containing alumina powder (250), mullite powder (250), alkaline alumina silicate powder (250), and/or rare earth silicate powder (250), and optionally SiC powder (250) as a filler, wherein the powders (250) fill void spaces within the infiltrated preform;
(e) introducing molten oxide into the slurry infiltrated CMC preform (200) by melt infiltration; and
(f) subjecting the melt infiltrated CMC preform (200) to one or more heat treatments to react the molten oxide and powder(s) to form a crystalline oxide matrix phase and obtain a ceramic matrix composite having matrix that has a carbide matrix phase (230) and an oxide matrix phase.

2. The method according to claim 1, wherein the CMC preform (200) is prepared by stacking two-dimensional woven ceramic fiber plies containing ceramic fiber tows (210, 220) and a binder.

3. The method according to claim 1, wherein the CMC preform (200) is a three-dimensional weave of ceramic fiber tows (210, 220) wherein the fiber tows are optionally embedded within a binder.

4. The method according to any preceding claim, wherein, prior to infiltration of the CMC preform (200) with a SiC matrix phase (230), the fiber tows (210, 220) are coated with an interphase, the interphase being selected from boron nitride, silicon-doped boron nitride, or boron-doped carbon.

5. The method according to any preceding claim, wherein the carbide matrix (230) is a silicon carbide, boron carbide, hafnium carbide, or zirconium carbide matrix (230), and the one or more metal oxide layer(s) (240) are selected from alumina, silicon dioxide, hafnium oxide, ytterbium oxide, and yttrium oxide.

6. The method according to any preceding claim, wherein a plurality of metal oxide layers (240) are deposited by ALD, wherein the metal oxide layers (240) deposited by ALD are the same or different, optionally wherein one of more silicon dioxide layers are deposited by ALD and then one or more alumina layers are deposited by ALD.

7. The method according to any preceding claim, wherein the total thickness of the one or more metal oxide layers (240) deposited by ALD is 10 to 200 nm (such as 50 - 200 nm or 50 to 100 nm).

8. The method according to any preceding claim, wherein the resultant ceramic matrix composite contains 30 - 50 vol.% fiber tows and 50 - 70 vol.% matrix, wherein the carbide matrix phase (230) is 10 - 30 vol.%, relative to the total volume of the composite, and the oxide matrix phase is 20 - 60 vol.%, relative to the total volume of the composite, optionally wherein cordierite (Mg₂Al₄Si₅O₁₈), mullite (Al₆Si₂O₁₃), and/or sapphirine (Mg₄Al₁₀Si₂O₂₃) make up greater than 75 vol.% of the of the oxide matrix phase.

9. The method according to any preceding claim, wherein in the resultant ceramic matrix composite the volume fraction of the pores that are filled with alumina is 25 vol.% to 75 vol.% relative to the total pore volume.

10. The method according to any preceding claim, wherein in the resultant ceramic matrix composite the volume of the pores that are filled with mullite is 35 vol.% to 85 vol.% relative to the total pore volume; and/or wherein in the resultant ceramic matrix composite the volume of the pores that are filled with carbide is 1 vol.% to 50 vol.% relative to the total pore volume.

11. The method according to any preceding claim, wherein the molten oxide infiltration is performed at 1350°C to 1500°C.

12. The method according to any preceding claim, in (e) the heat treatment(s) are performed at a temperature of 1100°C to 1500°C.

13. A CMC preform intermediate comprising fiber tows (210, 220) within a carbide matrix (230) and one or more metal oxide layer(s) (240) deposited by ALD on surfaces of the carbide matrix (230), wherein the preform intermediate contains 30 - 50 vol.% fiber tows and 10 - 30 vol.% of carbide matrix.

14. The CMC preform intermediate according to claim 13, wherein:
the fiber tows (210, 220) are coated with an interphase, the interphase being selected from boron nitride, silicon-doped boron nitride, or boron-doped carbon; and/or
the carbide matrix (230) is a silicon carbide, boron carbide, hafnium carbide, or zirconium carbide matrix (230), and the one or more metal oxide layer(s) (240) are selected from alumina, silicon dioxide, hafnium oxide, ytterbium oxide, and yttrium oxide; and/or
the total thickness of the one or more metal oxide layers (240) deposited by ALD is 10 to 200 nm (such as 50 - 200 nm or 50 to 100 nm).

15. A CMC jet engine component having a matrix with a carbide matrix phase (230) and an oxide matrix phase, prepared by a process comprising:
(a) preparing a CMC preform (200) containing fiber tows (210, 220);
(b) infiltrating the CMC preform with a carbide matrix phase (230) by chemical vapor infiltration (CVI);
(c) depositing one or more metal oxide layer(s) (240) on surfaces of the CMC preform (210) with carbide matrix phase (230) by atomic layer deposition (ALD);
(d) subjecting the CMC preform (200) with carbide matrix (230) and metal oxide layer(s) (240) to slurry infiltration using a slurry containing alumina powder (250), mullite powder (250), alkaline alumina silicate powder (250), and/or rare earth silicate powder (250), and optionally SiC powder (250) as a filler, wherein the powders (250) fill void spaces within the infiltrated preform (200), and heating the slurry infiltrated CMC preform (200) to melt the powders (250) and obtain a ceramic matrix composite having matrix that has an carbide matrix phase (230) and an oxide matrix phase;
(e) introducing molten oxide into the slurry infiltrated CMC preform (200) by melt infiltration; and
(f) subjecting the melt infiltrated CMC preform (200) to one or more heat treatments to react the molten oxide and powder(s) to form a crystalline oxide matrix phase and obtain a ceramic matrix composite having matrix that has a carbide matrix phase (230) and an oxide matrix phase.
